# EUROPEAN PATENT SPECIFICATION

(11) **EP 3 035 354 B1**
(45) Date of publication and mention of the grant of the patent: **01.04.2020**
(21) Application number: 15382563.3
(22) Date of filing: 12.11.2015
(51) Int. Cl.: H01H 9/08, H01H 23/04, H02G 3/12, H02G 3/14, H01H 9/02

(54) **FASTENING SYSTEM WITH EASY REMOVAL FOR ELECTRICAL AND / OR ELECTRONIC DEVICES**
BEFESTIGUNGSSYSTEM MIT EINFACHER ENTFERNUNG FÜR ELEKTRISCHE UND/ODER ELEKTRONISCHE VORRICHTUNGEN
SYSTÈME DE FIXATION PRÉSENTANT UN RETRAIT FACILE POUR DES DISPOSITIFS ÉLECTRIQUES ET/OU ÉLECTRONIQUES

(30) Priority: 18.12.2014 ES 201431871
(43) Date of publication of application: 22.06.2016
(73) Proprietor: Simon, S.A.U., 08013 Barcelona (ES)
(72) Inventor: ACIÉN FERNÁNDEZ, Jonatan, 08013 Barcelona (ES); ARDERIU COSTAS, Jordi, 08013 Barcelona (ES)
(74) Representative: Espiell Volart, Eduardo Maria

(56) References cited:
- DE-A1-102005 000 020
- DE-T2-602005 004 108
- FR-A1- 2 842 031
- US-A1- 2007 125 635

## Description

### OBJECT OF THE INVENTION

The invention as expressed in the title of this specification, refers to a fastening system with easy removal for electrical and / or electronic devices.

Specifically, the present invention focuses on a fastening system, meaning the organized assembly of elements enabling fastening, by clip pressure between a support frame or similar support and electrical and / or electronic devices that are installed on said support frame, said assembly of elements presenting the specific feature of being structurally designed to carry out the removal or "unclipping" of such pieces in a much easier way than that permitted by conventional systems currently used for the same purpose

### SCOPE OF THE INVENTION

The scope of the present invention falls within the Industry sector dedicated to the manufacture of equipment, mechanisms and devices of electrical and electronic material, and related accessories.

### BACKGROUND OF THE INVENTION

Currently, the electrical and / or electronic devices installed on boxes or similar places, comprise a support frame or support, for example consisting of a frame-shaped metal plate with a central recess, which is incorporated fixed to the box, and to which, in turn, is coupled inserted into said recess, the device in question, one of the most used solutions for this fastening, consisting of a system that acts by pressure or clipping.

More particularly, the assembly of elements creating the pressure fastening between the support frame and the box of the mechanism contemplate the existence of at least two flexible flaps that emerge on the sides of the device and which tend to expand outwardly at their distal end, oriented towards the top of the box, so that by introducing them in the recess of the support frame, they are pressed by the edge of it, and once introduced, they exert pressure towards said edges clamping both parts together.

Two examples of this type of system are known from US 2007/0125635 A1 and DE 60 2005 004 108 T2, each of them comprising the features of the preamble of claim 1. Each system comprises a support frame in which a device fits. The device carries flexible flaps that, once the device is placed in the frame, presses an edge of said frame in order to fasten the device to the support.

The problem, however, arises at the time of having to remove the device from the support frame, for which it is essential to retract all such flaps in unison, pushing in the direction opposite to that to which they tend, using a fingernail or a tool.

This operation is therefore indeed difficult, especially for more than two flaps and further due to the fact that all the flaps need to be kept pressed together until the complete removal of the mechanism box inside the recess of the support frame, because as soon as one stops pressing or the flap is released for any reason, their tendency to expand again places pressure on the edge of the recess of the frame and the process needs to be repeated.

It would therefore be desirable to have a fastening system which, without compromising its effectiveness, allows easy removal of the device, being the object of this invention to develop a new fastening system that achieves to facilitate such operation.

As reference to the current state of the art, it is noteworthy that, at least the applicant is not aware of any other fastening system for electrical and / or electronic devices having similar technical, structural and constitutive features to those the claimed herein

### EXPLANATION OF THE INVENTION

The fastening system with easy removal for electrical and / or electronic devices proposed by the invention is therefore configured as a remarkable novelty in its scope, since according to its implementation the aforementioned objective is successfully achieved, the characterizing features that make it possible and which distinguish it being conveniently collected in the final claims attached to this specification.

What the invention proposes, is thus a fastening system, to fasten the electrical and / or electronic device to the support frame or similar support which is configured as an assembly of elements which act by clip pressure, with the particular feature of being designed with a structural configuration which in addition to effective fastening, allows easy removal of said pieces.

For this purpose, said assembly has flexible flaps that diverge from the side of the device and which tend to expand outwardly at their distal end, facing the top of the device, so that by introducing these into the recess of the support frame, they are pressed by the edge of it and, once introduced, they exert pressure to said edges clamping both parts together.

Furthermore, and based on this configuration as known in the prior art, the distal ends of the flexible flaps described have protrusions that emerge on the outside and at the distal ends thereof, being provided to penetrate into corresponding slots located coinciding in the inner edge of the recess of the support frame or support (hereinafter support frame only), so that the fastening cannot move laterally and the fixing of the mechanism box in the recess of the frame is more effective.

It is also important to note that the above protrusions emerging from the outside and at the ends of the flexible flaps of the device are arranged at an angle and not perpendicular to the flaps, the slots of the edge of the frame being equally disposed at an angle and not perpendicular to the edge on which they are found, and with the same orientation as the corresponding protrusion which they receive, as they act as a guide for insertion thereof.

This inclination of the protrusions of the flaps of the device and of the slots of the edge of the recess of the support frame pose no problem when inserting the box into the hole in the recess of the support frame, rather the opposite, since in this operation the flaps retract by the very pressure of the edge and the protrusions fit into the slots which act as a guide by sliding the device into the recess of the support frame. But also, precisely this inclination of the protrusion and slots allows easy removal or "unclipping" of the protrusions from their fitting in the slots and faster and simpler removal of the device.

This is possible because, when the flaps are retracted to remove the device and extract it from the recess in the support frame, in being inclined protrusions, when attempting to expand to their initial position, they do not fit into the inclined slots and therefore lock onto the edge of the recess of the support frame, and thus no longer penetrate, resulting in easier removal of the device, and especially when there are more than two clip elements on the same device.

### DESCRIPTION OF THE DRAWINGS

To complement the description being made and in order to aid a better understanding of the characteristics of the invention, this descriptive specification is accompanied, as an integral part thereof, by a set of drawings wherein by way of example and without limiting the scope of the invention, the following is shown:
- Figure 1: shows a perspective view of a support frame and the base of an electrical and / or electronic device incorporating an embodiment of the fastening system with easy disengagement for electrical and / or electronic devices of the invention, which are shown before their mutual coupling depicting the parts and elements comprised;
- Figure 2: shows a side elevational view of the base shown in the example of Figure 1, showing the configuration of the flexible flap that incorporates and the protrusion provided in said flap and its inclined position;
- Figure 3: shows an enlarged view of detail A identified in Figure 2 and which allows to observe more clearly the said flexible flap of the base;
- Figure 4: shows a plan view of the support frame and the base with the fastening system according to the invention, shown in the preceding figures, in this case represented once coupled together;
- Figure 5: shows an enlarged view of detail B identified in Figure 4 and showing the coupling of the protrusion of the flexible flap to the slot of the edge of the support frame;
- Figures 6 and 7: show respective views similar to Figure 5 of the protrusion the flexible flap and the slot of the support frame, in respective phases of decoupling of them, showing in Figure 6 the lateral displacement undergone by the flap and in Figure 7 how the protrusion, once outside, locks onto the edge of the support frame and no longer fits in the slot; and
- Figure 8: shows another example support frame with multiple oblique slots to show how the oblique arrangement of the slots need not be fixed.

### PREFERRED EMBODIMENT OF THE INVENTION

In view of the mentioned figures and according to the adopted numbering, a preferred example of embodiment, without limiting the scope of the invention, of the fastening system with easy removal for electrical and / or electronic devices of the invention is noted, comprising the parts and elements indicated and described in detail below.

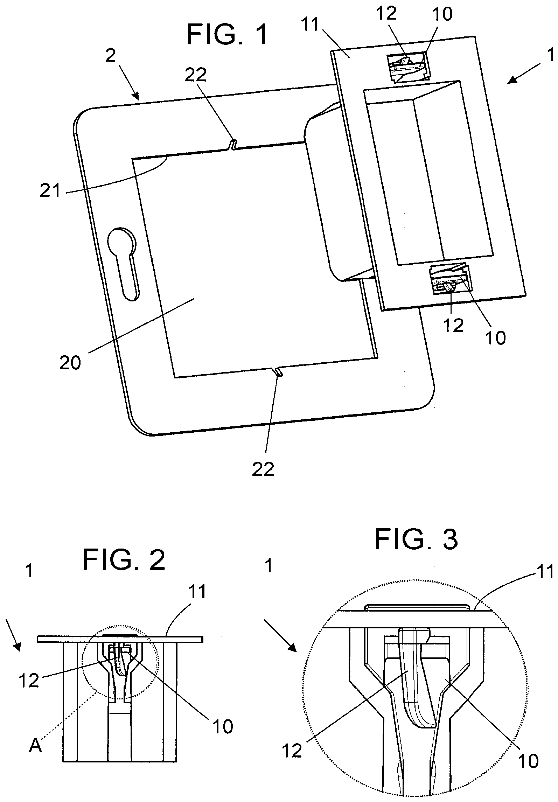

Thus, as shown in Figure 1, the fastening system in question, for the fixing devices to the support frame (2) or support, is configured as an assembly of elements which act by clip pressure comprising the existence of, at least two flexible flaps (10) diverging from opposite sides of the base (1) of the device and which tend to expand outwardly at their distal end, facing towards the top (11) of said base (1), and which by inserting the base (1) in the recess (20) of the support frame (2), said flexible flaps (10) are pressed by the edge (21) of said recess. After inserting the base (1) into the recess (20), the flexible flaps (10) exert pressure on said edge (21) providing attachment between the base (1) and the support frame (2).

Furthermore, on the external part of the distal ends of said flexible flaps (10) there are some protrusions (12) emerging on the outside of each flap and on the distal end thereof, as is clearly observed in Figure 3, which fit into slots (22) provided on the edge (21) of two opposite sides of the recess (20) of the support frame (2), preventing any lateral movement between the base (1) and the support frame (2).

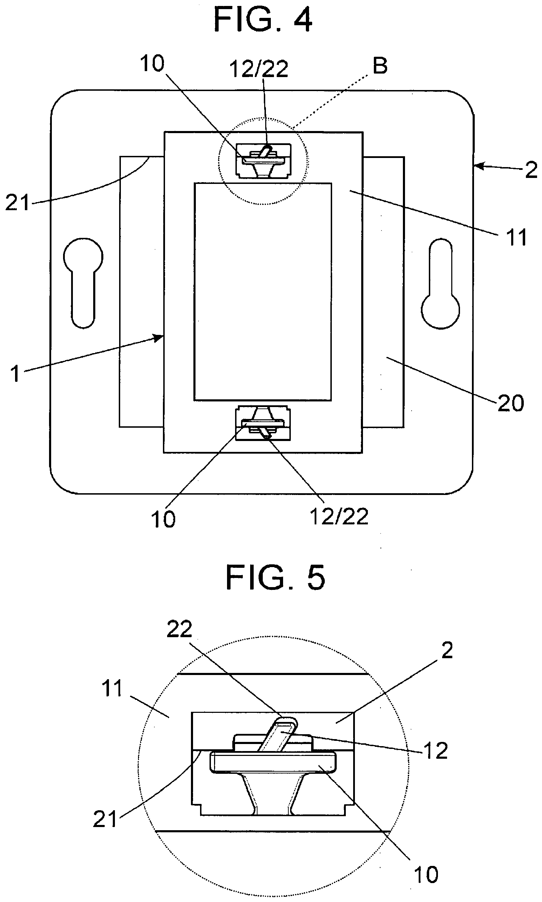

Said protrusions (12) also emerge from the outer end portion of the flexible flaps (10) at an angle, that is, not perpendicular to the surface of the flexible flap (10) on which they are found, the slots (22) of the edge (21) of the recess (20) of the support frame (2) also being arranged obliquely with the same orientation as the protrusions (12), as seen in the detail of Figure 5.

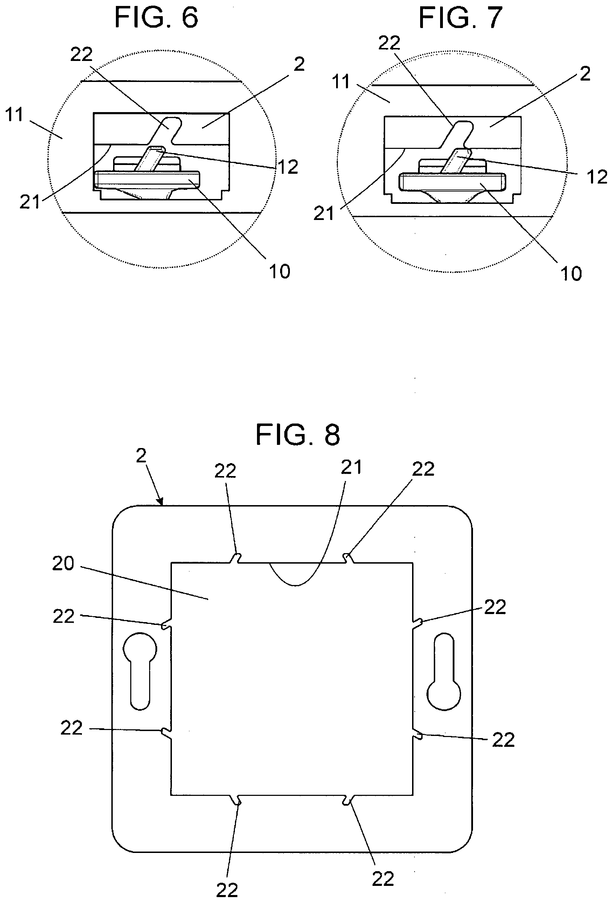

This inclination of the protrusions (12) and slots (22) which can be directed either to one side or the other, provides greater ease in the removal of the base (1) to extract it from the support frame (2), because, as shown in Figures 6 and 7, for this, by retracting the flexible flap (10) and sliding the protrusion (12) outside the slot (22) with an oblique movement of the flap, its tendency to expand again perpendicularly towards the edge (21) of the recess (20) of the support frame (2) means that the protrusion (12) is not introduced back into the slot (22), yet bumps into said edge (21) in being slightly shifted from the mouth of said slot (22), which prevents the flap (10) from becoming locked again, facilitating the extraction of the whole device.

It accordance with Figure 8, a single support frame (2) may have more than two slots (22) at the edges (21) of the recess (20) and / or to allow the incorporation of more than one device base (1) and to vary the position thereof and place it in either direction.

In any case, it is noted that the oblique slots (22) of the edges (21) of the support frame (2), for the engagement of the protrusions (12) of the base (1), may be oriented with their inclination to the same side, as in the example of support frame (2) shown in figure 1 or as are the slots (22) of the top and bottom edges (21) of the example support frame (2) shown in figure 8, or they may be oriented with their inclination towards opposite sides, as are the slots (22) of the opposite lateral edges (21) of said example of support frame (2) shown in figure 8.

Having sufficiently described the nature of this invention, as well as how to implement it, it is not considered necessary to extend its explanation for anyone skilled in the art to understand its scope and the advantages that derive from it, and referred to, it may be implemented in other embodiments which differ in detail from that indicated by way of example, and which are also covered by the appended claims.

## Claims

1. Fastening system with easy removal for electrical and / or electronic devices which are fixed into recesses (20) on a support frame (2), of the type using flexible flaps (10) arranged in the device, the flexible flaps (10) having a surface of the outer part, such that, upon insertion of the device into the recess (20) of the support frame (2), they become pressed by an edge (21) of said recess (20) and, once inserted, they exert pressure on said edge (21) to achieve the attachment of the device onto the support frame (2), **characterized by** comprising:
• a support frame (2) comprising at least two oblique slots (22) provided in the edge (21) of the recess (20) of the support frame (2); and
• an electrical and / or electronic device comprising at least two flexible flaps (10) on whose outer part of their distal ends there is a protrusion (12) emerging obliquely, that is, not perpendicular to the surface of the outer part of the flexible flap (10), protrusions (12) which in their clamping position will remain locked in the slots (22) of the support frame (2).

2. Support frame (2) for use on a fastening system according to claim 1, which comprises a recess (20) having an edge (21), which upon insertion of a device having flexible flaps (10) into the recess (20), press on an outer part of the flexible flaps (10) and, once the device is inserted, the flexible flaps (10) exert pressure on said edge (21) to achieve the attachment of the device onto the support frame **characterized in that** the edge (21) comprises at least two oblique slots (22), which are arranged two to two in symmetrical positions on opposite sides of the recess (20).

3. Support frame according to claim 2, **characterized in that** all the oblique slots (22) of each side of the recess (20) have the same inclination.

4. Device for use on a fastening system according to claim 1, with flexible flaps (10), such that, upon insertion of the device into a recess (20) of a support frame (2), they become pressed by an edge (21) of said recess (20) on an outer part of the flexible flap (10) and, once inserted, they exert pressure on said edge (21) to achieve the attachment of the device onto the support frame (2), **characterized in that** it comprises at least two flexible flaps (10) on whose outer part of their distal ends there is a protrusion (12) emerging obliquely, that is, not perpendicular to the outer surface of the flexible flap (10).

5. Device according to claim 4, **characterized in that** it has a base (1) where the flexible flaps (10) are located.

## Patentansprüche

1. Befestigungssystem mit einfacher Entfernung für elektrische und/oder elektronische Vorrichtungen, die in Aussparungen (20) auf einem Tragrahmen (2) fixiert sind, von der Art, die flexible Laschen (10) verwendet, die in der Vorrichtung angeordnet sind, wobei die flexiblen Laschen (10) eine Oberfläche des Außenteils aufweisen, sodass sie beim Einsetzen der Vorrichtung in die Aussparung (20) des Tragrahmens (2) von einer Kante (21) der Aussparung (20) gedrückt werden und sobald sie eingesetzt sind, einen Druck auf die Kante (21) ausüben, um die Anbringung der Vorrichtung an dem Tragrahmen (2) zu erreichen, **dadurch gekennzeichnet, dass** es Folgendes umfasst:
• einen Tragrahmen (2), aufweisend mindestens zwei schräge Schlitze (22), die in der Kante (21) der Aussparung (20) des Tragrahmens (2) bereitgestellt sind; und
• eine elektrische und/oder elektronische Vorrichtung, umfassend mindestens zwei flexible Laschen (10), an deren Außenteil von ihren distalen Enden ein Vorsprung (12) schräg austritt, d. h. nicht senkrecht zu der Oberfläche des Außenteils der flexiblen Lasche (10), Vorsprünge (12), die in ihrer Klemmstellung in den Schlitzen (22) des Tragrahmens (2) verriegelt bleiben.

2. Tragrahmen (2) zur Verwendung an einem Befestigungssystem nach Anspruch 1, der eine Aussparung (20) mit einer Kante (21) aufweist, die beim Einsetzen einer Vorrichtung mit flexiblen Laschen (10) in die Aussparung (20) auf einen Außenteil der flexiblen Laschen (10) drücken und sobald die Vorrichtung eingesetzt ist, über die flexiblen Laschen (10) Druck auf die Kante (21) aus, um die Anbringung der Vorrichtung an dem Tragrahmen zu erreichen, **dadurch gekennzeichnet, dass** die Kante (21) mindestens zwei schräge Schlitze (22) umfasst, die paarweise in symmetrischen Positionen an gegenüberliegenden Seiten der Aussparung (20) angeordnet sind.

3. Tragrahmen nach Anspruch 2, **dadurch gekennzeichnet, dass** alle schrägen Schlitze (22) von jeder Seite der Aussparung (20) die gleiche Neigung aufweisen.

4. Vorrichtung zur Verwendung an einem Befestigungssystem nach Anspruch 1 mit flexiblen Laschen (10), sodass sie beim Einsetzen der Vorrichtung in eine Aussparung (20) eines Tragrahmens (2) von einer Kante (21) der Aussparung (20) an einem Außenteil der flexiblen Lasche (10) gedrückt wird und sobald sie eingesetzt sind, üben sie Druck auf die Kante (21) aus, um die Anbringung der Vorrichtung an dem Tragrahmen (2) zu erreichen, **dadurch gekennzeichnet, dass** sie mindestens zwei flexible Laschen (10) umfasst, an deren Außenteil von ihren distalen Enden ein Vorsprung (12) schräg austritt, d. h. nicht senkrecht zu der Außenfläche der flexiblen Laschen (10).

5. Vorrichtung nach Anspruch 4, **dadurch gekennzeichnet, dass** sie eine Basis (1) aufweist, an der die flexiblen Laschen (10) angeordnet sind.

## Revendications

1. Système de fixation à retrait facile pour des dispositifs électriques et/ou électroniques qui sont fixés dans des renfoncements (20) sur un cadre de support (2), du type utilisant des rabats souples (10) disposés dans le dispositif, les rabats souples (10) ayant une surface de la partie externe, de sorte que, lors de l'insertion du dispositif dans le renfoncement (20) du cadre de support (2), ils sont enfoncés par un bord (21) dudit renfoncement (20) et, une fois insérés, ils exercent une pression sur ledit bord (21) pour obtenir le raccordement du dispositif sur le cadre de support (2), **caractérisé en ce qu'**il comprend :
• un cadre de support (2) comprenant au moins deux fentes obliques (22) prévues dans le bord (21) du renfoncement (20) du cadre de support (2) ; et
• un dispositif électrique et/ou électronique comprenant au moins deux rabats souples (10) sur la partie externe de leurs extrémités distales desquels se trouve une saillie (12) émergeant obliquement, qui est, non perpendiculaire à la surface de la partie externe du rabat souple (10), des saillies (12) qui, dans leur position de serrage, resteront verrouillées dans les fentes (22) du cadre de support (2).

2. Cadre de support (2) en vue d'être utilisé sur un système de fixation selon la revendication 1, qui comprend un renfoncement (20) ayant un bord (21), qui, lors de l'insertion d'un dispositif ayant des rabats souples (10) dans le renfoncement (20), enfonce une partie externe des rabats souples (10) et, une fois l'appareil inséré, les rabats souples (10) exercent une pression sur ledit bord (21) pour obtenir le raccordement du dispositif sur le cadre de support **caractérisé en ce que** le bord (21) comprend au moins deux fentes obliques (22), qui sont disposées deux à deux dans des positions symétriques sur les côtés opposés du renfoncement (20).

3. Cadre de support selon la revendication 2, **caractérisé en ce que** toutes les fentes obliques (22) de chaque côté du renfoncement (20) ont la même inclinaison.

4. Dispositif en vue d'être utilisé sur un système de fixation selon la revendication 1, avec des rabats souples (10), de sorte que, lors de l'insertion du dispositif dans un renfoncement (20) d'un cadre de support (2), ils sont enfoncés par un bord (21) dudit renfoncement (20) sur une partie externe du rabat souple (10) et, une fois insérés, ils exercent une pression sur ledit bord (21) pour obtenir le raccordement du dispositif sur le cadre de support (2), **caractérisé en ce qu'**il comprend au moins deux rabats souples (10), sur la partie externe de leurs extrémités distales desquels se trouve une saillie (12) émergeant obliquement, qui est, non perpendiculaire à la surface externe du rabat souple (10).

5. Dispositif selon la revendication 4, **caractérisé en ce qu'**il a une base (1) où sont situés les rabats souples (10).
